(19) Europäisches Patentamt
European Patent Office
Office européen des brevets

(11) EP 1 048 112 B1

(12) # EUROPÄISCHE PATENTSCHRIFT

(45) Veröffentlichungstag und Bekanntmachung des Hinweises auf die Patenterteilung:
**16.07.2003 Patentblatt 2003/29**

(21) Anmeldenummer: **99964373.7**

(22) Anmeldetag: **24.11.1999**

(51) Int Cl.[7]: **H03M 7/00**

(86) Internationale Anmeldenummer:
**PCT/DE99/03727**

(87) Internationale Veröffentlichungsnummer:
**WO 00/031877 (02.06.2000 Gazette 2000/22)**

(54) **SIGMA-DELTA-D/A-WANDLER**

SIGMA-DELTA-D/A-CONVERTER

CONVERTISSEUR NUMERIQUE ANALOGIQUE SIGMA-DELTA

(84) Benannte Vertragsstaaten:
**DE FR GB**

(30) Priorität: **24.11.1998 DE 19854124**

(43) Veröffentlichungstag der Anmeldung:
**02.11.2000 Patentblatt 2000/44**

(73) Patentinhaber: **ROBERT BOSCH GMBH**
**70442 Stuttgart (DE)**

(72) Erfinder:
- **JELONNEK, Bjoern**
  **D-89079 Ulm (DE)**
- **NYENHUIS, Detlev**
  **D-31079 Sibesse (DE)**

(56) Entgegenhaltungen:
**EP-A- 0 308 194** **US-A- 4 692 737**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).



Printed by Jouve, 75001 PARIS (FR)

## Beschreibung

### Technisches Gebiet

Die Erfindung betrifft einen Sigma Delta D/A-Wandler mit N Stufen, wobei die n-te Stufe, mit n = 1, 2, 3 ... N, folgendes umfasst, einen ersten Addierer, welcher ein Nutzsignal bzw. Nutzsignal x(k) mit einem Fehlersignal $err_n$(k-1) zu einem Eingangssignal $e_n$(k) addiert, einem Quantisierer, welcher das Eingangssignal $e_n$(k) gemäß einer vorbestimmten Quantisierungsfunktion zu einem Ausgangssignal $y_n$(k) quantisiert, sowie einem zweiten Addierer, welcher das Eingangssignal $e_n$(k) mit dem invertierten Ausgangssignal $y_n$(k) zu $x_n$(k) addiert und einem Verzögerungsglied zuführt, welches das Signal $x_n$(k) um eine Taktperiode verzögert als das Fehlersignal $err_n$(k-1) an den ersten Addierer abgibt, gemäß dem Oberbegriff des Anspruchs 1.

### Stand der Technik

Ein gattungsgemäßer Sigma Delta D/A-Wandler ist aus dem Buch "Delta Sigma Data Converter, Theory, Design and Simulation" von Steven R. Norsworthy, Richard Schreiner und Gabor C. Temes, IEEE Press 1997, ISBN 0-7803-1045-4 bekannt. Derartige bekannte Sigma Delta D/A-Wandler haben den Nachteil, dass diese nicht asymptotisch stabil, kurz a-stabil, sind. Hierbei werden vom Sigma Delta D/A-Wandler ggf. unerwünschte Grenzzyklen erzeugt, wenn das Eingangssignal des Wandlers Null ist, d.h. wenn der Wandler nicht angeregt wird. Diese Grenzzyklen können dabei ggf. hohe Amplituden annehmen, welche beispielsweise in Modulationspausen eines Rundfunknutzsignals als NF-Amplitude hörbar werden oder das Signal-Rausch-Verhältnis verschlechtern. Ferner erzeugen Sigma Delta D/A-Wandler ohne Eingangssignal ein sogn. "digitales Rauschen", d.h. ein "Null-Eingangssignal" ($x(k) \equiv 0$ für alle $k >= k_0$) wird nicht eindeutig auf ein "Null-Ausgangssignal" abgebildet, sondern auf eine Folge von Ausgangswerten des D/A-Wandlers, die um die Nulllage pendeln und somit ein Rauschen erzeugen. Der Grund hierfür liegt in idealen diskreten Integratoren sowie in den verwendeten Quantisierern. Die vorgenannten Effekte beeinträchtigt die Funktionstüchtigkeit und Einsatzfähigkeit derartiger D/A-Wandler.

### Darstellung der Erfindung, Aufgabe, Lösung, Vorteile

Es ist Aufgabe der vorliegenden Erfindung, einen verbesserten Sigma Delta D/A-Wandler der obengenannten Art zur Verfügung zu stellen, welcher die obengenannten Nachteile beseitigt.

Diese Aufgabe wird durch einen Sigma Delta D/A-Wandler der o.g. Art mit den in Anspruch 1 gekennzeichneten Merkmalen gelöst.

Dazu ist es erfindungsgemäß vorgesehen, dass zwischen dem zweiten Addierer und dem Verzögerungsglied ein Betragsminderer vorgesehen ist, welcher das Signal $x_n$(k) unverändert belässt, wenn $x_n$(k)=0 ist und ansonsten den Betrag $|x_n(k)|$ des Signals $x_n$(k) um wenigstens eine kleinste darstellbare Zahleneinheit erniedrigt, wobei die Quantisierungsfunktion des Quantisierers der n-ten Stufe des Sigma Delta D/A-Wandlers folgendermaßen lautet,

$$y_n(k) = \begin{cases} 2^{(1-n)}, \textit{falls} \;\; e_n(k) > 2^{-n} \\ 0 \quad\;\;\;, \textit{falls} \;\; abs(e_n(k)) \le 2^{-n} \\ -2^{(1-n)}, \textit{falls} \;\; e_n(k) < -2^{-n} \end{cases}$$

wobei abs() die Betragsfunktion darstellt. Dies hat den Vorteil, dass der erfindungsgemäße Sigma Delta D/A-Wandler ein asymptotisch stabiles Verhalten aufweist, d.h. alle beliebigen Startwerte der Integratoren des Sigma Delta D/A-Wandlers erreichen in endlicher Zeit den Zustand Null. Ferner ist eine Anzahl benötigter Ausgangsstufen des D/A-Wandlers minimiert, was einen nachfolgenden Schaltungsaufwand reduziert.

Vorzugsweise Weitergestaltungen der Vorrichtung sind in den Ansprüchen 2 bis 4 beschrieben.

So ist zweckmäßigerweise ein Nutzsignal der n-ten Stufe, mit n>1, das Ausgangssignal $x_{n-1}$(k) des zweiten Addierers der (n-1)-ten Stufe, wobei bei zwei oder mehr Stufen die n-te Stufe (n-1) Differenzierer aufweist, welche dem Quantisierer nachgeschaltet sind.

Eine abschließende Zusammenführung der Ausgangssignale aller Stufen erzielt man dadurch, dass die ersten (N-1) Stufen, mit N>1, jeweils einen dritten Addierer aufweisen, welcher im Falle der ersten Stufe dem Quantisierer und im Falle der zweiten bis (N-1)-ten Stufe den Differenzieren nachgeschaltet ist, wobei jeder dritte Addierer der ersten bis zur (N-2)-ten Stufen mit dem jeweiligen dritten Addierer der nächst höheren Stufe verbunden ist und der

dritte Addierer der (N-1)-Stufe mit dem letzten Differenzierer der N-ten Stufe verbunden ist.

Kurze Beschreibung der Zeichnungen

Nachstehend wird die Erfindung anhand der beigefügten Zeichnungen näher erläutert. Diese zeigen in

Fig. 1 eine erste Bevorzugte Ausführungsform eines erfindungsgemäßen Sigma Delta D/A-Wandlers,

Fig. 2 eine zweite Bevorzugte Ausführungsform eines erfindungsgemäßen Sigma Delta D/A-Wandlers und

Fig. 3 eine dritte Bevorzugte Ausführungsform eines erfindungsgemäßen Sigma Delta D/A-Wandlers.

Bester Weg zur Ausführung der Erfindung

Die in Figur 1 dargestellte erste bevorzugte Ausführungsform eines erfindungsgemäßen Sigma Delta D/A-Wandlers 100 ist vom einstufigen Typ (N = 1) und umfasst einen ersten Addierer 10, welcher ein Nutzsignal x(k) bei 12 erhält und mit einem Fehlersignal $err_1(k-1)$ zu einem Eingangssignal $e_1(k)$ bei 14 addiert. Ein nachfolgender Quantisierer 16 quantisiert das Eingangssignal $e_1(k)$ gemäß einer vorbestimmten Quantisierungsfunktion zu einem Ausgangssignal $y_1(k)$ bei 18. Ein zweiter Addierer 20 addiert das Eingangssignal $e_1(k)$ mit dem invertierten Ausgangssignal $y_1(k)$ zu $x_1(k)$ bei 21 und führt dieses einem Verzögerungsglied 22 zu, welches das Signal $x_1(k)$ um eine Taktperiode verzögert als das Fehlersignal $err_1(k-1)$ an den ersten Addierer 10 abgibt

Zwischen dem zweiten Addierer 20 und dem Verzögerungsglied 22 ist ein Betragsminderer 24 vorgesehen, welcher das Signal $x_1(k)$ unverändert belässt, wenn $x_1(k)=0$ ist und ansonsten den Betrag $|x_1(k)|$ des Signals $x_1(k)$ um wenigstens eine kleinste darstellbare Zahleneinheit erniedrigt. Ein entsprechendes Ausgangssignal $z_1(k)$ des Betragsminderers 24 liegt bei 26 vor und bildet das Eingangssignal für das Verzögerungsglied 22. Die Quantisierungsfunktion $q_1(e_1(k))$ des Quantisierers dieser einzigen Stufe des Sigma-Delta-D/A-Wandlers lautet erfindungsgemäß folgendermaßen:

$$y_1(k) = \begin{cases} 1, \textit{falls} \;\; e_1(k) > \tfrac{1}{2} \\ 0, \textit{falls} \;\; abs(e_1(k)) \leq \tfrac{1}{2} \\ -1, \textit{falls} \;\; e_1(k) < -\tfrac{1}{2} \end{cases}$$

Hierbei bezeichnet k = 1, 2, 3, ... etc. den k-ten Abtastwert und ist somit äquivalent zu einer diskreten Zeit. Bei einer Abtastfrequenz $f_a$ ist eine Zeit- bzw. Periodendauer T zwischen zwei Abtastvorgängen gegeben durch $T = 1/f_a$. Somit entspricht der k-te Abtastwert einer vergangenen Zeit $t(k) = k*T$.

Die in Fig. 2 dargestellte zweite bevorzugte Ausführungsform eines erfindungsgemäßen Sigma Delta D/A-Wandlers 200 ist vom zweistufigen Typ (N = 2), wobei zwei Stufen der Art gemäß Fig. 1 derart miteinander kombiniert sind, dass der Ausgang $x_1(k)$ des zweiten Addierers 20 der ersten Stufe als Eingangssignal für den ersten Addierer 10 der zweiten Stufe dient. Ferner ist dem Quantisierer 16 der zweiten Stufe ein digitaler Differenzierer 28 nachgeschaltet, dessen Ausgang einem Eingang eines zusätzlichen dritten Addierers 30 der ersten Stufe zugeführt wird, so dass sich bei 32 das Ausgangssignal y(k) ergibt. Alle in den jeweiligen Stufen gleiche Teile sind mit gleichen Bezugsziffern bezeichnet, so dass zu deren Erläuterung auf obige Ausführungen in Bezug auf Fig. 1 verwiesen wird. Ferner ist für die zweite Stufe der jeweilige Index n des Eingangssignals $e_n(k)$ bei 14, des Ausgangssignals $y_n(k)$ bei 18, des Signals $x_n(k)$ bei 21 und $z_n(k)$ bei 26 um eins zu erhöhen, so dass in der zweiten Stufe an den angegebenen Orten die Signale $e_2(k)$, $y_2(k)$, $x_2(k)$ und $z_2(k)$ vorliegen.

Die Quantisierungsfunktion $q_1(e_1(k))$ der ersten Stufe entspricht derjenigen gemäß der ersten bevorzugten Ausführungsform 100 gemäß Fig. 1. Die Quantisierungsfunktion $q_2(e_2(k))$ der zweiten Stufe lautet:

$$y_2(k)=\begin{cases} 1/2\,, falls\;\; e_2(k) > 1/4 \\ 0\,, falls\;\; abs(e_2(k)) \le 1/4 \\ -1/2\,, falls\;\; e_2(k) < -1/4 \end{cases}$$

In der dritten bevorzugten Ausführungsform eines erfindungsgemäßen Sigma Delta D/A-Wandlers 300 ist analog zur zweiten Ausführungsform 200 eine dritte Stufe vorgesehen (N = 3), welche zwei Differenzierer 28 aufweist. Alle in den jeweiligen Stufen gleiche Teile sind mit gleichen Bezugsziffern bezeichnet, so dass zu deren Erläuterung auf obige Ausführungen in Bezug auf Fig. 1 und 2 verwiesen wird. Die entsprechenden Signale $e_3(k)$, $y_3(k)$, $x_3(k)$ und $z_3(k)$ der dritten Stufe liegen jeweils an den Orten 14, 18, 21 und 26 vor. Die jeweiligen Ausgangssignale $y_1(k)$, $y_2(k)$ und $y_3(k)$ sind wieder über die dritten Addierer 30 der jeweiligen Stufen zum Ausgangssignal y(k) bei 32 zusammengeführt.

Die Quantisierungsfunktionen $q_1(e_1(k))$ und $q_2(e_2(k))$ der ersten und zweiten Stufe entsprechen jeweils der Quantisierungsfunktion der ersten und zweiten Stufe gemäß der zweiten Ausführungsform 200 von Fig. 2. Die Quantisierungsfunktion $q_3(e_3(k))$ der dritten Stufe lautet:

$$y_3(k)=\begin{cases} 1/4\,, falls\;\; e_3(k) > 1/8 \\ 0\,, falls\;\; abs(e_3(k)) \le 1/8 \\ -1/4\,, falls\;\; e_3(k) < -1/8 \end{cases}$$

Für eine Ausführungsform mit n Stufen, wobei n = 1, 2, 3, ... N, lautet die jeweilige Quantisierungsfunktion $q_n(e_n(k))$ der n-ten Stufe folgendermaßen:

$$y_n(k)=\begin{cases} 2^{(1-n)}\,, falls\;\; e_n(k) > 2^{-n} \\ 0\qquad\;, falls\;\; abs(e_n(k)) \le 2^{-n} \\ -2^{(1-n)}\,, falls\;\; e_n(k) < -2^{-n} \end{cases}$$

mit jeweiligen Signalen $e_n(k)$, $y_n(k)$, $x_n(k)$ und $z_n(k)$, welche in der n-ten Stufe jeweils bei 14, 18, 21 und 26 vorliegen. Nach dem jeweils letzten Differenzierglied 28 der zweiten und jeder nachfolgenden n-ten Stufe ergibt sich ein jeweiliges Signal $y_{nd}(k)$ 34.

Der Betragsminderer 24 der jeweiligen Stufe führt dazu, dass nicht in herkömmlicherweise auf- bzw. abgerundet wird, sondern dass sich der Betrag des Signals $x_n(k)$ immer vermindert, es sei denn $x_n(k) = 0$. Mit anderen Worten entzieht jeder Betragsminderer 24 dem Sigma Delta D/A-Wandler Energie, so dass es sich bereits daraus anschaulich ergibt, dass es zu keinen Grenzzyklen kommen kann. Dies soll jedoch zusätzlich nachfolgend anhand der ersten bevorzugten Ausführungsform 100 gemäß Fig. 1 auch mathematisch verdeutlicht werden.

x(k) ist das digitale Eingangssignal bei 12 mit einem Wertebereich zwischen -1 und 1. $e_1(k)$ ist das Eingangssignal des Quantisierers 16. y(k) ist das Ausgangssignal des einstufigen Sigma Delta D/A-Wandlers 100 bei 32. In diesem Fall des einstufigen Sigma Delta A/D-Wandlers gilt $y_1(k) = y(k)$. Das Eingangssignal x(k) sei für den $k_0$-ten Abtastwert und davor, d.h. also bis zum Zeitpunkt $t_0 = k_0 * T$, nicht identisch Null und ab dem Zeitpunkt $t_0$ sei x(k) = 0, d.h.

$$x(k)=\begin{cases} x(k)\,,\, k < k_0 \\ 0\qquad, sonst \end{cases}$$

Beispielsweise in Kommunikationssystemen tritt dieser Fall auf, wenn ab $t_0$ eine Modulationspause vorhanden ist. Im Verzögerungsglied 22 steht zu diesem Zeitpunkt $t_0$ ein Zahlenwert I0, den man als Anfangswert oder Startwert

für einen Zeitabschnitt auffassen kann, in dem keine Anregung des Sigma Delta D/A-Wandlers existiert. Der Betragsminderer 24 führt folgende Funktion aus:

$$z_1(k) = \begin{cases} x_1(k) + 1LSB, & falls\ \ x_1(k) < 0 \\ 0 & , falls\ \ x_1(k) = 0 \\ x_1(k) - 1LSB, & falls\ \ x_1(k) > 0 \end{cases}$$

Hierbei bezeichnet LSB eine kleinste darstellbare Zahleneinheit. Alternativ ist es vorgesehen ein vielfaches von LSB zu addieren bzw. zu subtrahieren.

Es sei nun zum Zeitpunkt $t_0$ I0 = vz *b/$2^{(w-1)}$, wobei vz das Vorzeichen + bzw. -, b ein Zahlenwert und w eine Wortbreite in Zweierkomplementdarstellung ist. Beispielsweise bei 16 Bit ergibt sich eine Wertigkeit von 15 Bit, wobei ein Bit als Vorzeichen dient.

Im ersten Fall sei b > $2^{14}$, was einem Wert im Verzögerungsglied von I0 > ½ entspricht. Somit ergibt sich

$$e_1(k) = B[e_1(k-1)-y_1(k-1)]$$

$$= B[e_1(k-1) - q_1(e_1(k-1))]$$

wobei B die Betragsminderungsfunktion des Betragsminderers 24 und $q_1$ die Quantisierungsfunktion des Quantisierers 16 ist. Ferner gilt gemäß Annahme und durch Einsetzen

$$e_1(0) = I0 = b/2^{15} > ½$$

$$e_1(1) = B[b/2^{15} - 2^{15}/2^{15}], \qquad e_1(0)>½ \Rightarrow q(e_1(0))=1$$

$$= B[(b-2^{15})/ 2^{15}], \qquad (b-2^{15})/ 2^{15} < 0$$

$$= (b+1-2^{15})/2^{15}$$

Es gilt: 0 > $e_1(1)$ > -½

$$e_1(2) = B[e_1(1) - q(e_1(1))], \qquad q(e_1(1))=0$$

$$= B[e_1(1)]$$

$$= (b+2-2^{15})/2^{15}$$

somit ergibt sich allgemein :

$$e_1(k) = \begin{cases} \frac{(b+k-2^{15})}{2^{15}}, & falls\ b+k < 2^{15} \\ 0 & , sonst \end{cases}$$

Für die Ausgangsfolge $y_1(k)$ ergibt sich somit

$$y_1(k) = \begin{cases} 1, & falls\ k = 0 \\ 0 & , sonst \end{cases}$$

Im zweiten Fall sei $0 < b < 2^{14}$. Dann gilt analog

$$e_1(k) = \begin{cases} \frac{(b-k)}{2^{15}} & , falls\ b-k > 0 \\ 0 & , sonst \end{cases}$$

und $y_1(k)=0$ für alle k. Der dritte Fall mit $2^{14}<b<0$ beweist sich analog zum zweiten Fall und der vierte Fall mit $b<-2^{14}$ beweist sich analog zum ersten Fall.

Sowohl im betrachteten einstufigen Fall als auch bei Ausführungsformen 200 bzw. 300 mit mehreren Stufen liefert die erste Stufe des Sigma Delta D/A-Wandlers bei fehlender Anregung, d.h. Eingangssignal x(k) identisch Null, nach endlicher Zeit das Signal $e_1(k) = 0$. Diese Zeit lässt sich für den schlechtesten Fall folgendermaßen abschätzen:

$$t_{max} = (½*2^{(w-1)}+1)*T \qquad \text{mit } T = 1/f_a,\ f_a \text{ Abtastfrequenz}$$

Nach dieser Maximalzeit ist das Signal $e_1(k) = 0$ und somit ebenfalls das Ausgangssignal des zweiten Addierers 20 $x_1(k) = 0$. Die zweite Stufe arbeitet analog zur ersten Stufe und liefert nach endlicher Zeit das Ausgangssignal $y_2(k) = 0$. Dieses Prinzip ist in naheliegender Weise auf n-stufige Sigma Delta D/A-Wandler ausdehnbar.

Es ergibt sich ferner durch die Wahl der erfindungsgemäßen Quantisierer der jeweiligen Stufen eine Reduktion des Wertebereiches des Ausgangssignals y(k), was nachfolgend anhand des zweistufigen Sigma Delta D/A-Wandlers 200 gemäß Fig. 2 näher erläutert wird.

Das Signal $y_1(k)$ nach dem Quantisierer 16 der ersten Stufe hat die möglichen Werte 1, 0, -1. Das Signal $y_2(k)$ nach dem Quantisierer 16 der zweiten Stufe hat die möglichen Werte ½, 0, -½. Nach dem Differenzierglied 28 in der zweiten Stufe ergeben sich für $y_{2d}(k)$ die möglichen Werte 1, ½, 0, -½, -1. Das Signal y(k) nach dem dritten Addierer 30 der ersten Stufe hat somit die möglichen Werte

2, 1½, 1, ½, 0, -½, -1, -1½, -2

Jedoch existieren die Werte 2 und -2 am Ausgang 32 nicht, wie sich durch Widerspruch zeigen lässt:

Annahme: y(k)=2

$$y(k) = 2 \Leftrightarrow y_1(k) = 1 \text{ und } y_{2d}(k) = 1$$

$$\Leftrightarrow y_1(k) = 1 \text{ und } y_2(k) = ½ \text{ und } y_2(k-1) = -½$$

$$\Leftrightarrow e_1(k) > ½ \text{ und } e_2(k) > ¼ \text{ und } e_2(k-1) < -¼$$

Mit $q_1, q_2, \ldots q_n$ gleich der jeweiligen Quantisierungsfunktion der 1-ten, 2-ten, ... n-ten Stufe ergibt sich ferner:

$$e_2(k) = e_2(k-1) - q_2(e_2(k-1)) + (e_1(k) - q_1(e_1(k)))$$

$$= -¼-eps_1 - (-½) + (½+eps_2 - 1) \qquad \text{mit } eps_1, eps_2 > 0$$

$$= eps_2 - eps_1 - ¼$$

$$\Leftrightarrow ¼ + eps_3 = eps_2 - eps_1 - ¼ \qquad \text{mit eps3} > 0$$

$$\Leftrightarrow ½ = eps_2 - eps_1 - eps_3$$

Dies ist jedoch ein Widerspruch, da $eps_2$ <= ½ und $eps_1$, $eps_3$ > 0. Analog ergibt sich, dass y(k) = -2 nicht möglich ist.

Für die dritte bevorzugte Ausführungsform eines erfindungsgemäßen Sigma Delta D/A-Wandlers 300 gemäß Fig. 3 ergibt sich für den möglichen Wertebereich des Ausgangssignals y(k) bei 32 folgendes:

Das Signal $y_1(k)$ hat die möglichen Werte 1, 0, -1.
Das Signal $y_2(k)$ hat die möglichen Werte ½, 0, -½.
Das Signal $y_3(k)$ hat die möglichen Werte %, 0, -¼.

Nach dem Differnezierglied 28 der zweiten Stufe hat $y_{2d}(k)$ die möglichen Werte

1, ½, 0, -½, -1.

Nach dem zweichen Differenzierglied 28 der dritten Stufe hat $y_{3d}(k)$ die möglichen Werte

1, ¾, ½, ¼, 0, -¼, -½, -¾, -1.

Das Signal y(k) hat bei 32 damit folgenden theoretischen Wertebereich:
3, 2.75, 2.5, 2.25, 2, 1.75, 1.5, 1.25, 1, 0.75, 0.5, 0.25, 0, -0.25, -0.5, -0.75, -1, -1.25, -1.5, -1.75, -2, -2.25, -2.5, -2.75, -3

Von diesen 25 Zuständen treten nur die folgenden 15 Zustände auf,
1.75, 1.5, 1.25, 1, 0.75, 0.5, 0.25, 0, -0.25, -0.5, -0.75, -1, -1.25, -1.5,
-1.75
was sich wiederum durch analogen Widerspruch wie zuvor beweisen lässt.

Zusammenfassend ergibst sich erfindungsgemäß ein Sigma Delta D/A-Wandler mit asymptotisch stabilem Verhalten, beispielsweise mit drei Stufen (Fig. 3), bei dem keine Grenzzyklen existieren und der ein Eingangssignal Null in endlicher Zeit auf ein Ausgangssignal Null abbildet, wodurch sich eine Minimierung des Rauschens in solchen Zeiten ergibt, in denen der erfindungsgemäße Sigma Delta D/A-Wandler nicht angeregt wird. Durch die spezielle Wahl der Quantisierungsfunktion $q_n(e_n(k)$ benötigt beispielsweise der dreistufige Sigma Delta D/A-Wandler 300 gemäß Fig. 3 lediglich 15 Ausgangsstufen, wodurch sich ein entsprechender Aufwand nachfolgender Schaltungen, beispielsweise eines Widerstandsnetzwerkes oder entsprechender Strompumpen, auch bei hohen Wortbreiten w von beispielsweise 32 Bit, erheblich reduziert.

## Patentansprüche

1. Sigma Delta D/A-Wandler (100, 200, 300) mit N Stufen, wobei die n-te Stufe, mit n = 1, 2, 3 ... N, folgendes umfasst: einen ersten Addierer (10), welcher ein Nutzsignal x(k) (12) mit einem Fehlersignal $err_n(k-1)$ zu einem Eingangssignal $e_n(k)$ (14) addiert, einen Quantisierer (16), welcher das Eingangssignal $e_n(k)$ (14) gemäß einer vorbestimmten Quantisierungsfunktion zu einem Ausgangssignal $y_n(k)$ (18) quantisiert, sowie einen zweiten Addierer (20), welcher das Eingangssignal $e_n(k)$ (14) mit dem invertierten Ausgangssignal $y_n(k)$ zu $x_n(k)$ (21) addiert und einem Verzögerungsglied (22) zuführt, welches das Signal $x_n(k)$ (21) um eine Taktperiode verzögert als das Fehlersignal $err_n(k-1)$ an den ersten Addierer (10) abgibt,
**dadurch gekennzeichnet, dass**
zwischen dem zweiten Addierer (20) und dem Verzögerungsglied (22) ein Betragsminderer (24) vorgesehen ist, welcher das Signal $x_n(k)$ (21) unverändert belässt, wenn $x_n(k)=0$ ist und ansonsten den Betrag $|x_n(k)|$ des Signals $x_n(k)$ (21) um wenigstens eine kleinste darstellbare Zahleneinheit erniedrigt, wobei die Quantisierungsfunktion des Quantisierers (16) der n-ten Stufe des Sigma Delta D/A-Wandlers (100, 200, 300) folgendermaßen lautet,

$$y_n(k) = \begin{cases} 2^{(1-n)} & , falls \quad e_n(k) > 2^{-n} \\ 0 & , falls \quad abs(e_n(k)) \le 2^{-n} \\ -2^{(1-n)} & , falls \quad e_n(k) < -2^{-n} \end{cases}$$

**2.** Sigma Delta D/A-Wandler (200, 300) nach Anspruch 1,
**dadurch gekennzeichnet, dass**
ein Nutzsignal der n-ten Stufe, mit n>1, das Ausgangssignal $x_{n-1}(k)$ (21) des zweiten Addierers (20) der (n-1)-ten Stufe ist.

**3.** Sigma Delta D/A-Wandler (200, 300) nach Anspruch 1 oder 2,
**dadurch gekennzeichnet, dass**
die n-te Stufe (n-1) Differenzierer (28) aufweist, welche dem Quantisierer (16) nachgeschaltet sind.

**4.** Sigma Delta D/A-Wandler (200, 300) nach einem der vorhergehenden Ansprüche,
**dadurch gekennzeichnet, dass**
die ersten (N-1) Stufen, mit N>1, jeweils einen dritten Addierer (30) aufweisen, welcher im Falle der ersten Stufe dem Quantisierer (16) und im Falle der zweiten bis (N-1)-ten Stufe den Differenzieren (28) nachgeschaltet ist, wobei jeder dritte Addierer (30) der ersten bis zur (N-2)-ten Stufen mit dem jeweiligen dritten Addierer (30) der nächst höheren Stufe verbunden ist und der dritte Addierer (30) der (N-1)-Stufe mit dem letzten Differenzierer (28) der N-ten Stufe verbunden ist.

## Claims

**1.** Sigma-delta D/A converter (100, 200, 300) having N stages, the nth stage, where n = 1, 2, 3 ... N, comprising the following: a first adder (10) which adds a useful signal x(k) (12) to an error signal $err_n(k-1)$ to form an input signal $e_n(k)$ (14), a quantizer (16) which quantizes the input signal $e_n(k)$ (14) in accordance with a predetermined quantization function to form an output signal $y_n(k)$ (18), and a second adder (20), which adds the input signal $e_n(k)$ (14) to the inverted output signal $y_n(k)$ to form $x_n(k)$ (21) and feeds it to a time-delay element 922) which outputs the signal $x_n(k)$ (21), delayed by one clock period, as the error signal $err_n(k-1)$ to the first adder (10), **characterized in that** provided between the second adder (20) and the time delay element (22) is an absolute-value decrementer (24) which leaves a signal $x_n(k)$ (21) unaltered when $x_n(k) = 0$ and otherwise lowers the absolute value $|x_n(k)|$ of the signal $x_n(k)$ (21) by at least a smallest representable numerical unit, the quantization function of the quantizer (16) of the nth stage of the sigma-delta D/A converter (100, 200, 300) being as follows:

$$y_n(k) = \begin{cases} 2^{(1-n)} & , \textbf{if} \quad e_n(k) > 2^{-n} \\ 0 & , \textbf{if} \quad abs(e_n(k)) \le 2^{-n} \\ -2^{(1-n)} & , \textbf{if} \quad e_n(k) < -2^{-n} \end{cases}$$

**2.** Sigma-delta D/A converter (200, 300) according to Claim 1, **characterized in that** a useful signal of the nth stage, where n>1, is the output signal $x_{n-1}(k)$ (21) of the second adder (20) of the (n-1)th stage.

**3.** Sigma-delta D/A converter (200, 300) according to Claim 1 or 2, **characterized in that** the nth stage has (n-1) differentiators (28) which are connected downstream of the quantizer (16).

**4.** Sigma-delta D/A converter (200, 300) according to one of the preceding claims, **characterized in that** the first (N-1) stages, where N>1, each have a third adder (30) which in the case of the first stage is connected downstream of the quantizer (16), and in the case of the second to (N-1)th stage is connected downstream of the differentiators (28), each third adder (30) of the first to (N-2)th stages being connected to the respective third adder (30) of the

next higher stage, and the third adder (30) of the (N-1) stage being connected to the last differentiator (28) of the Nth stage.

## Revendications

**1.** Convertisseur numérique analogique sigma delta (100, 200, 300) à N étages, dans lequel l'étage de rang n, avec n = 1, 2, 3 ... N comprend :

- un premier additionneur, qui additionne un signal utile x(k) (12) à un signal d'erreur $err_n(k-1)$ pour donner un signal d'entrée $e_n(k)$ (14)
- un quantificateur (16) qui quantifie le signal d'entrée $e_n(k)$ (14) selon une fonction prédéfinie de quantification pour donner un signal de sortie $y_n(k)$ (18)
- un deuxième additionneur (20) qui additionne le signal d'entrée $e_n(k)$ (14) et le signal de sortie $y_n(k)$ inversé pour donner le signal $x_n(k)$ (21) et l'envoie à un organe de retardement (22) qui ralentit ce signal (21) d'une période de rythme et le délivre en tant que signal d'erreur $err_n(k\text{-}^1)$ au premier additionneur (10),

**caractérisé en ce que**
il est prévu entre le deuxième additionneur (20) et l'organe de retardement (22), un réducteur de valeur (24) qui laisse le signal $x_n(k)$ (21) inchangé si $x_n(k)$ = O et, dans les autres cas, abaisse la valeur absolue $|x_n(k)|$ de signal $x_n(k)$ (21) d'au moins la plus petite unité représentable, la fonction de quantification du quantificateur (16) de l'étage de rang n de convertisseur (100, 200, 300) se présentant comme suit:

$$y_n(k) = \begin{cases} 2^{(1-n)}, & \text{si} \quad e_n(k) > 2^{-n} \\ 0, & \text{si} \quad abs(e_n(k)) \leq 2^{-n} \\ -2^{(1-n)}, & \text{si} \quad e_n(k) < -2^{-n} \end{cases}$$

**2.** Convertisseur (200, 300) selon la revendication 1,
**caractérisé en ce que**
le signal utile de l'étage de rang n, avec n>1, est le signal de sortie $x_{n-1}(k)$ (21) du deuxième additionneur (20) de l'étage de rang n-1.

**3.** Convertisseur (200, 300) selon la revendication 1 ou 2,
**caractérisé en ce que**
l'étage de rang (n-1) présente un différenciateur (28) relié au quantificateur (16) en aval de celui-ci.

**4.** Convertisseur (200,300) selon une des revendications précédentes ?
**caractérisé en ce que**
les premiers (N-1) étages, avec N>1, présentent chacun un troisième additionneur (30), qui, dans le cas du premier étage est relié en aval du quantificateur (16) et dans le cas des étages de rang 2 à (N-1) est relié en aval aux différenciateurs (28), chaque troisième additionneur (30) des étages du rang 1 à (N-2) étant relié au troisième additionneur (30) de l'étage de rang immédiatement supérieur, tandis que le troisième additionneur (30) de l'étage de rang (N-1) est relié au dernier différenciateur (28) de l'étage de rang N.

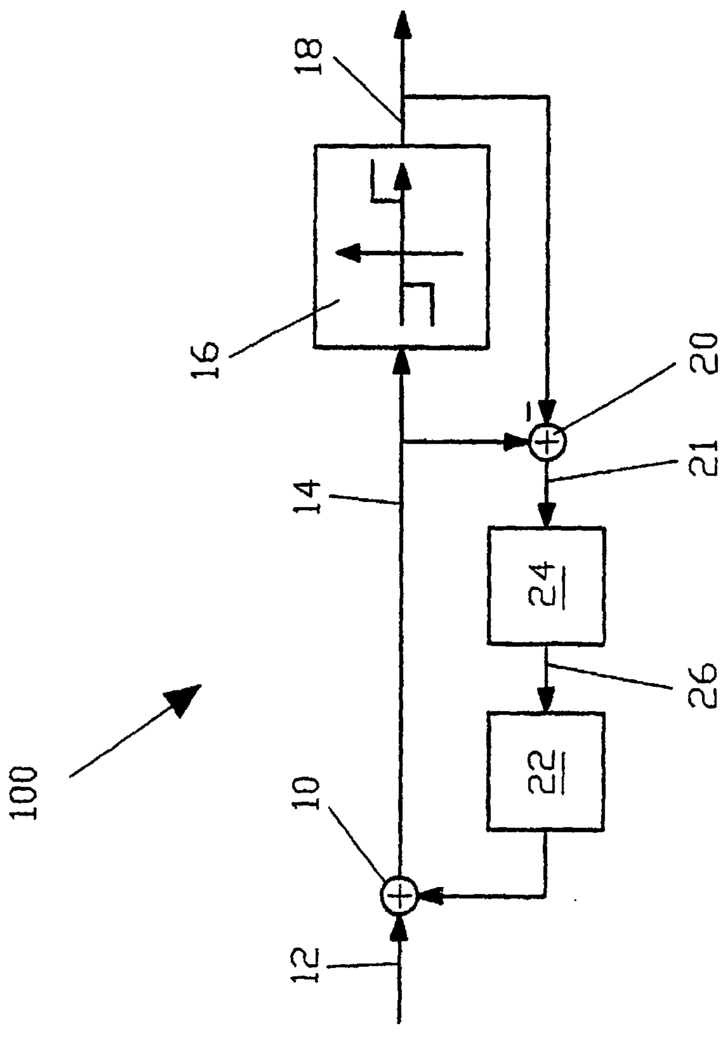


Fig.1

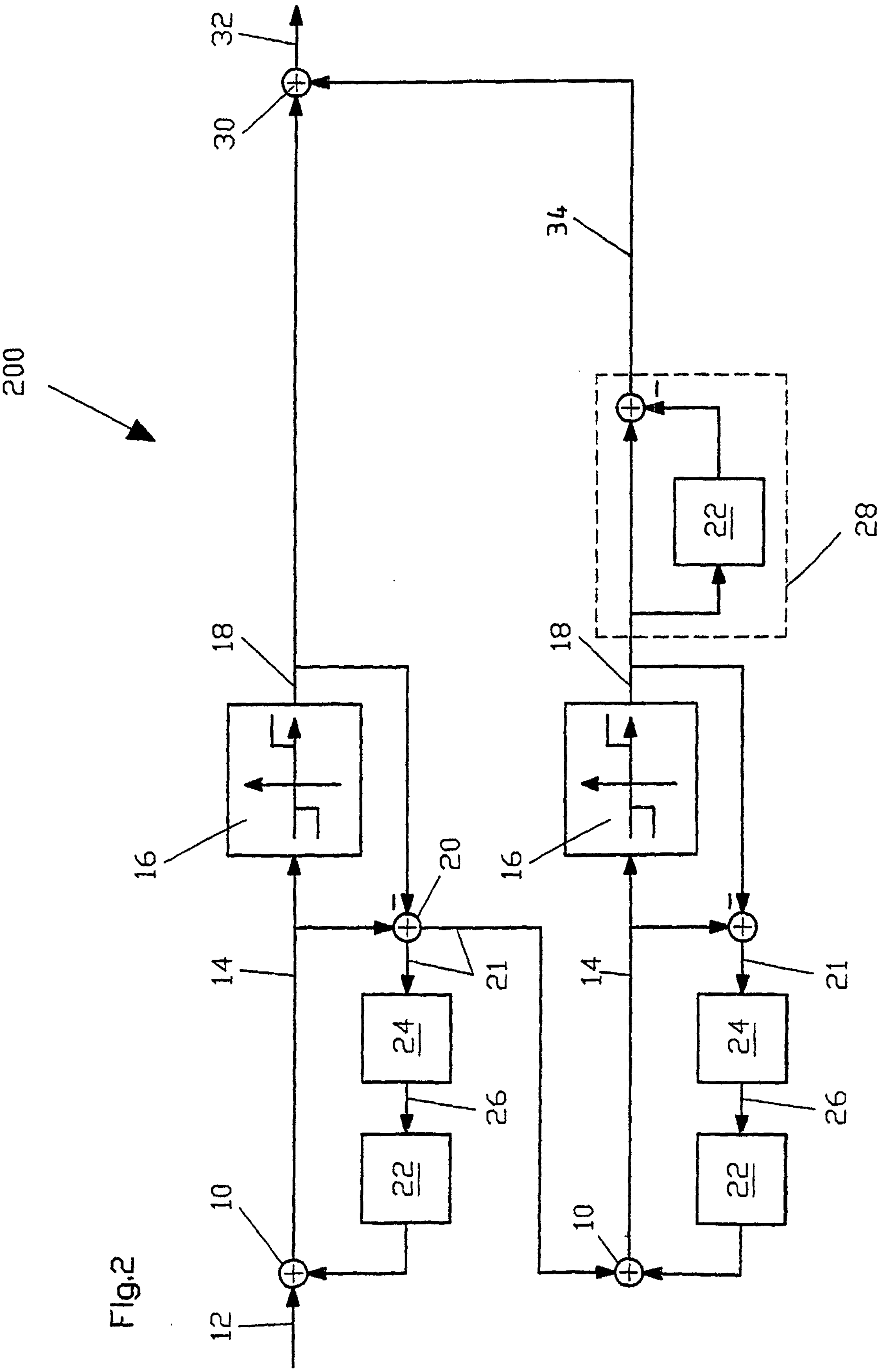


Fig.2

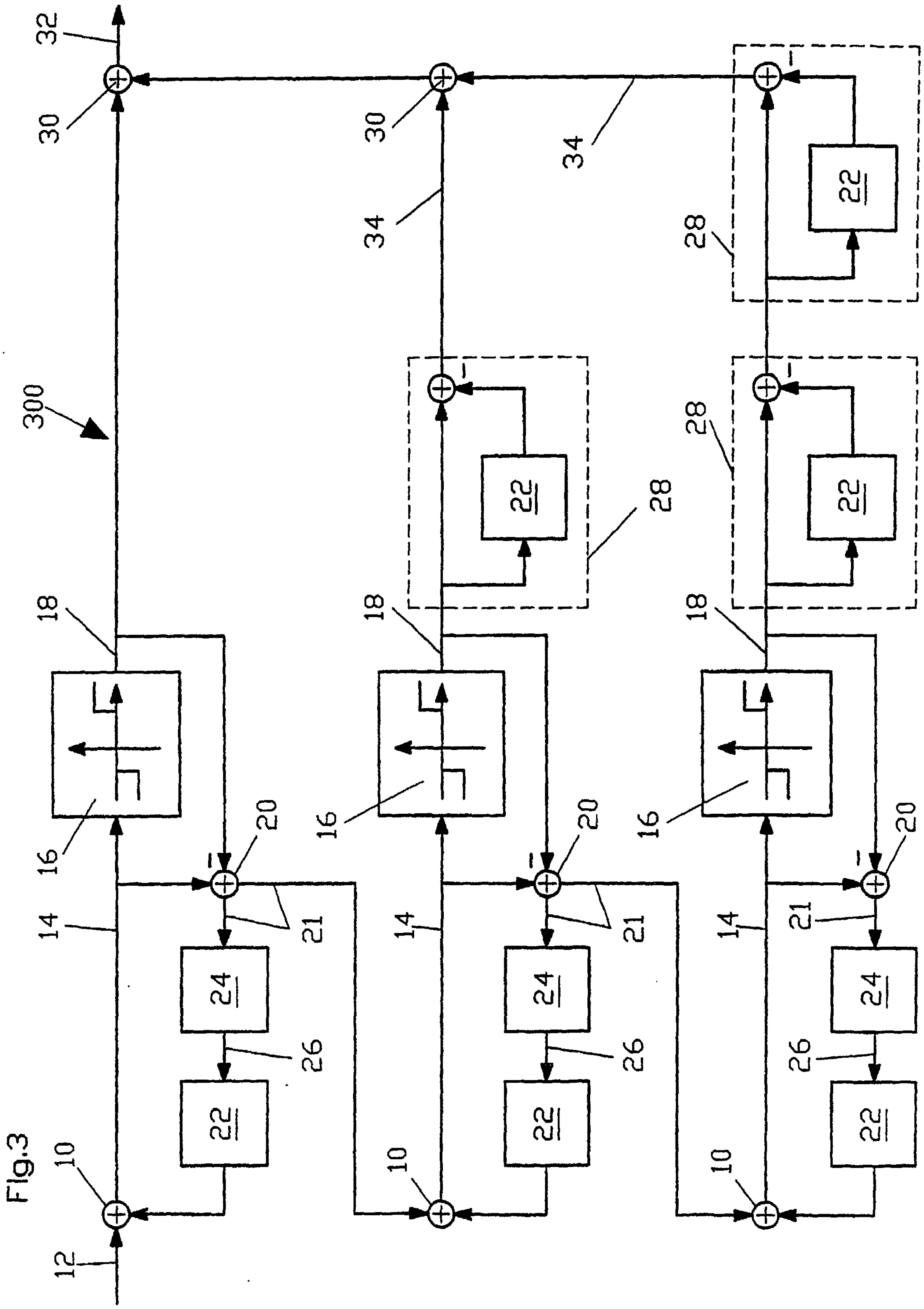


Fig.3